# EUROPÄISCHE PATENTSCHRIFT

(11) **EP 1 173 911 B1**
(45) Veröffentlichungstag und Bekanntmachung des Hinweises auf die Patenterteilung: **30.07.2008**
(21) Anmeldenummer: 00920524.6
(22) Anmeldetag: 21.03.2000
(51) Int. Cl.: H02B 1/28

(54) **GERÄTESCHRANK**
INSTRUMENT CABINET
ARMOIRE D'INSTRUMENTS

(30) Priorität: 30.03.1999 DE 19914408
(43) Veröffentlichungstag der Anmeldung: 23.01.2002
(73) Patentinhaber: Deutsche Telekom AG, 53113 Bonn (DE)
(72) Erfinder: KNIERIEM, Harald, D-64732 Bad König (DE)
(74) Vertreter: Katscher Habermann Patentanwälte
(86) Internationale Anmeldenummer: PCT/EP2000/002477
(87) Internationale Veröffentlichungsnummer: WO 2000/060713

(56) Entgegenhaltungen:
- EP-A- 0 514 668
- EP-A- 0 560 191
- DE-A- 2 911 920
- DE-A- 19 807 804

## Beschreibung

Die Erfindung betrifft einen Geräteschrank zum Einbau von elektronischen Geräten, bestehend aus einem Boden, Wandteilen, wenigstens einer Tür und einem Deckel, wobei im Geräteschrank Vorrichtungen zur Befestigung der Geräte, insbesondere Einschubhalterungen, angeordnet sind und wobei am Geräteschrank Kabeldurchführungen vorgesehen sind.

Ferner wird ein Verfahren zum Aufbau eines derartigen Geräteschranks angegeben.

Zum Schutz vor Bränden sollen Räume, in denen leistungsstarke elektronische Geräte, wie beispielsweise Netzwerkserver oder Modemschränke, aufgestellt werden, besondere Sicherheitsstandards (z.B. DIN 4102) erfüllen. Es ist vorzusehen, daß der Raum eine gewisse, vorgeschriebene Zeit lang einem Brand standhalten muß, ohne daß außerhalb des Raumes erhebliche Auswirkungen des Brandes zu verzeichnen sind.

Derartige Räume müssen, wenn sie den Anforderungen an Objekt- und Brandschutz nicht entsprechen, zumeist mit erheblichem Kostenaufwand ausgebaut und mit einer Klimaanlage ausgestattet werden. Bei einem häufigen Wechsel des Aufstellortes der Geräte muß jedesmal ein neuer Raum hergerichtet werden.

Derartige Räume sollen ferner gewisse Anforderungen an den Objektschutz (Zugangs-, Einbruchsschutz) erfüllen. Zur Kennzeichnung der Widerstandsfähigkeit gegen unbefugten Zugriff auf die elektronischen Einrichtungen gibt es Normen (DIN 18103 ET 3), wie ein Raum zu gestalten ist. Dabei treten analog die gleichen Probleme auf wie oben, wenn der Aufstellort häufig gewechselt wird.

Ferner wird gefordert, daß ein Raum zur Installation von elektronischen Geräten Schutz vor Feuchtigkeit, Spritzwasser, Staub, Vandalismus und Diebstahl bietet.

Um elektronische Geräte leicht transportieren und zusammenstellen zu können, sind Elektronikschränke erhältlich, die mit Einschubhalterungen zur Befestigung der Geräte ausgestattet sind. Derartige Schränke sind zum Anschluß der eingebauten Geräte an die Außenwelt mit Kabeldurchführungen versehen. Sie verfügen häufig über eingebaute Lüftungseinrichtungen und Spannungsquellen.

Aus DE 198 07 804 A ist beispielsweise bekannt, bei einem Geräteschrank Maßnahmen vorzusehen, um Schäden im Falle eines Brandes zu verringern. Diese Maßnahmen bestehen im Wesentlichen darin, daß eine Ventilatoröffnung geschlossen wird und gleichzeitig ein Löschgas unter Druck in den Schrank eingeführt wird. Dies hat jedoch den Nachteil, daß neben der Steuerung zur Schließung der Ventilatoröffnung eine zusätzliche Steuerung und Aufwand für die Aktivierung der Gasflaschen vorzusehen ist.

Ferner ist es aus EP 0 560 191 A1 bekannt, Abdichtungen an Türen eines Computer-Containers vorzusehen, die beim Erreichen einer hohen Temperatur selbstabdichtend wirken. Es werden jedoch auch hier automatische Löschanlagen mit den oben erwähnten Nachteilen vorgeschlagen.

Aufgabe der vorliegenden Erfindung ist es, einen Geräteschrank anzugeben, welcher die o.g. Anforderungen an den Brandschutz erfüllt und die eingebauten Geräte vor unbefugtem Zugriff schützt, wobei der Aufwand für die Herstellung und Wartung des Geräteschrankes vermindert wird.

Diese Aufgabe wird dadurch gelöst, daß die Wandteile demontierbar sind, daß Boden, Wandteile, Deckel und Türen aus feuerbeständigem Material gefertigt sind, daß eine Klimaanlage zur Regelung der Temperatur in dem Geräteschrank vorgesehen ist, daß die Klimaanlage über im Falle eines Brandes selbstschließende Lüftungsöffnungen verfügt, daß die Kabeldurchführungen als Brandschotts ausgebildet sind, welche im Brandfalle selbstabdichtend wirken, daß die Türen des Geräteschranks mit einem elektromechanischen Riegelwerk versehen sind, welches durch eine außen am Geräteschrank angebrachte wirkenden Dichtungen versehen sind. Bei Verwendung eines erfindungsgemäßen Geräteschranks erübrigt sich ein Raumausbau, da sämtliche Geräte hermetisch abgeschottet sind.

Ferner kann vorgesehen sein, dass Einrichtungen zur Überwachung und Aufzeichnung von Türöffnungen, Zugriffsversuchen, Brandereignissen, der Spannungsversorgung, der korrekten Funktion der Klimaanlage und der Temperatur im Geräteschrank vorhanden sind, welche über entsprechende Sensoren im Geräteschrank verfügen und dass die Einrichtungen mit Mitteln zum Abschalten der Spannungsversorgung der Geräte im Gefahrenfalle verbunden sind. Die Türen können im Brandfalle mittels eines Notschlüssels mechanisch entriegelt werden.

Beim Aufbau eines Geräteschranks während des Betriebs von Geräten, die in einem eigenen Geräteträger angeordnet sind, ist vorgesehen, dass der Geräteträger angehoben wird, dass der Geräteschrankboden untergeschoben wird, dass Geräteschrankteile montiert werden, dass die in die Schrankteile eingelassenen Brandschottrahmen mit Brandschutzmaterial versehen werden und dass die nach außen führenden Kabelstränge in die Brandschottrahmen eingelegt werden. Auf diese Weise lassen sich Geräte in einen erfindungsgemäßen Geräteschrank einbauen, ohne dass der Betrieb unterbrochen werden muss.

Die Brandschottrahmen an den Geräteschrankteilen sind so gestaltet, dass die Kabel offen durchgeführt werden können. Die Brandschottrahmen sind beispielsweise in die Seitenteile, den Deckel oder die Türen eingelassen und werden nach Einführung der Kabel beim Zusammensetzen des Schranks durch eine Metallschiene an dem jeweils gegenüberliegenden Schrankteil geschlossen.

Durch die in den weiteren Unteransprüchen aufgeführten Maßnahmen werden weitere vorteilhafte Weiterbildungen und Verbesserungen der Erfindung erreicht.

Ausführungsbeispiele der Erfindung sind in der Zeichnung anhand mehrerer Figuren dargestellt und in der nachfolgenden Beschreibung näher erläutert. Es zeigt:
- Fig. 1: einen erfindungsgemäßen Geräteschrank schematisch in Explosionsdarstellung und
- Fig. 2: einen zweitürigen Geräteschrank schematisch in Draufsicht.

Gleiche Teile sind in den Figuren mit gleichen Bezugszeichen versehen.

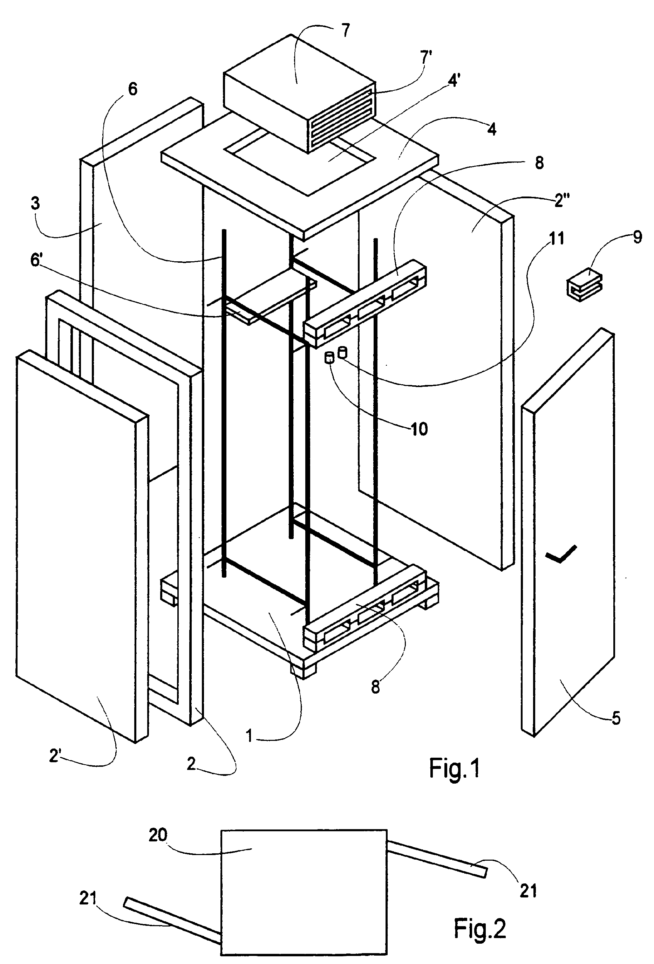

Fig. 1 zeigt einen erfindungsgemäßen Geräteschrank zum Einbau von elektronischen Geräten, wie Netzwerksteuer- und Versorgungsgeräten, Computern, Modemschränken und dergleichen, in Explosionsdarstellung. Auf einer Bodenplatte 1 aus feuerbeständigem Material werden die Seitenteile 2, 3, 2'' sowie ein Brandschottrahmen 8 zur Kabeldurchführung und ein Befestigungsgestell 6 mit Einschubfächern 6' der Breite 19 Zoll zur Befestigung von Einbaugeräten genormter Größe montiert. Eine dicht schließende Tür 5 ermöglicht den Zugriff auf das Schrankinnere. Der Deckel 4 des Geräteschranks hat eine Aussparung 4' zur Aufnahme einer Klimaanlage 7, welche die Temperatur im Inneren des Geräteschranks regelt und zur Wärmeabfuhr über Lüftungsöffnungen 7' verfügt. Bei alternativen Ausführungsformen kann vorgesehen sein, dass die Klimaanlage 7 in eine Seitenwand oder Tür eingesetzt ist. Ein Lesegerät 9 für Chipkarten ist außen am Geräteschrank befestigt. Durch Einschieben einer Chipkarte lässt sich die Tür 5 entriegeln.

Zur Überwachung des Schrankinnern sind Temperaturfühler 10 sowie ein Brandmelder 11 vorgesehen, die mit einer Versorgungs- und Überwachungseinrichtung 12 verbunden sind. Die Versorgungseinrichtung umfasst Klemmleisten zur Spannungsversorgung der im Schrank eingebauten Geräte und beinhaltet Stromsicherungen. Ferner dient sie zur Überwachung der Spannungsversorgung und anderer Betriebsgrößen. Die Überwachungseinrichtung registriert über nicht dargestellte Mikroschalter oder Reed-Kontakte, wenn der Schrank geöffnet wird. Ferner verfügt sie über Mittel zur Aufzeichnung der überwachten Größen, sowie zur Trennung der Spannungsversorgung im Falle einer Gefahr.

Die Spalten und Fugen zwischen den Einzelteilen des Geräteschranks, sowie die Lüftungsöffnungen 7' und Kabeldurchführungen 8 sind mit einer bei starker Erwärmung aufschäumenden Substanz ausgekleidet, damit im Brandfalle eine sichere Abdichtung erfolgt.

Fig. 2 zeigt einen anderen erfindungsgemäßen Geräteschrank 20 in Draufsicht. Bei diesem Ausführungsbeispiel sind an zwei Seiten Türen 21 angeordnet.

## Patentansprüche

1. Geräteschrank zum Einbau von elektronischen Geräten, bestehend aus einem Boden (1), Wandteilen (2, 2', 2", 3), wenigstens einer Tür (5) und einem Deckel (4), wobei im Geräteschrank Vorrichtungen zur Befestigung der Geräte, insbesondere Einschubhalterungen, angeordnet sind und wobei am Geräteschrank Kabeldurchführungen vorgesehen sind, **dadurch gekennzeichnet, daß** die Wandteile demontierbar sind, daß Boden (1), Wandteile (2, 2', 2", 3), Deckel (4) und Türen (5) aus feuerbeständigem Material gefertigt sind, daß eine Klimaanlage (7) zur Regelung der Temperatur in dem Geräteschrank vorgesehen ist, daß die Klimaanlage (7) über im Falle eines Brandes selbstschließende Lüftungsöffnungen (7') verfügt, daß die Kabeldurchführungen (8) als Brandschotts ausgebildet sind, welche im Brandfalle selbstabdichtend wirken, daß die Türen (5) des Geräteschranks mit einem elektromechanischen Riegelwerk versehen sind, welches durch eine außen am Geräteschrank angebrachte Betätigungsvorrichtung (9) entriegelbar ist, und daß die Türen (5) des Geräteschranks mit im Brandfalle selbstabdichtend wirkenden Dichtungen versehen sind.

2. Geräteschrank nach Anspruch 1, **dadurch gekennzeichnet, daß** Einrichtungen zur Überwachung und Aufzeichnung von Türöffnungen, Zugriffsversuchen, Brandereignissen, der Spannungsversorgung, der korrekten Funktion der Klimaanlage (7) und der Temperatur im Geräteschrank vorhanden sind, welche über entsprechende Sensoren (10, 11) im Geräteschrank verfügen, und daß die Einrichtungen mit Mitteln zum Abschalten der Spannungsversorgung der Geräte im Gefahrenfalle verbunden sind.

3. Geräteschrank nach einem der vorhergehenden Ansprüche, **dadurch gekennzeichnet, daß** die Lüftungsöffnungen (7') mit bei starker Erwärmung zur Abdichtung aufschäumenden Einsätzen versehen sind.

4. Geräteschrank nach einem der vorhergehenden Ansprüche, **dadurch gekennzeichnet, daß** die Klimaanlage (7) passend in eine dafür vorgesehene Öffnung (4') am Geräteschrank einsetzbar ist und daß die Lüftungsöffnungen (7') am Gehäuse der Klimaanlage (7) angeordnet sind.

5. Geräteschrank nach einem der vorhergehenden Ansprüche, **dadurch gekennzeichnet, daß** im Geräteschrank eine Vorrichtung zur Luftumwälzung/Belüftung angeordnet ist, welche wenigstens einen Lüfter enthält.

6. Geräteschrank nach einem der vorhergehenden Ansprüche, **dadurch gekennzeichnet, daß** die Brandschotts (8) mit einem bei starker Erwärmung zur Abdichtung aufschäumenden Material ausgestattet sind.

7. Geräteschrank nach Anspruch 6, **dadurch gekennzeichnet, daß** die Brandschotts zur Montage bereits angeschlossener Kabel über einen nach einer Seite offenen Rahmen (8) verfügen, in welchen das aufschäumende Material und die Kabel eingelegt sind, und daß an den Teilen des Geräteschranks Aussparungen oder Abteilungen zur Aufnahme der Brandschotts vorgesehen sind.

8. Geräteschrank nach einem der vorhergehenden Ansprüche, **dadurch gekennzeichnet, daß** zum Zusammenschließen mehrerer Schränke wenigstens Teile (2') der Seitenwände (2) entfernbar sind und die Schränke an den so entstehenden Öffnungen zusammenschließbar sind, wobei die Anschlußstellen mit bei starker Erwärmung aufschäumenden Dichtungen abgedichtet sind.

9. Geräteschrank nach einem der vorhergehenden Ansprüche, **dadurch gekennzeichnet, daß** zwischen den elektronischen Geräten und den Türen (5) zur Verlegung von Anschlußkabeln ein Freiraum vorgesehen ist.

10. Geräteschrank nach einem der vorhergehenden Ansprüche, **dadurch gekennzeichnet, daß** im Geräteschrank wenigstens eine Steckdosenleiste zum Anschluß der Geräte vorgesehen ist.

11. Geräteschrank nach einem der vorhergehenden Ansprüche, **dadurch gekennzeichnet, daß** die Spannungsversorgung der Geräte über eine Vorrichtung zur Spannungsüberwachung erfolgt.

12. Geräteschrank nach einem der vorhergehenden Ansprüche, **dadurch gekennzeichnet, daß** ein Kartenlesegerät (9) für Magnet- oder Chipkarten außen am Geräteschrank angeordnet ist und daß das Riegelwerk der Tür (5) über eine Steuereinrichtung im Inneren des Geräteschranks durch Einschieben einer Karte entriegelbar ist.

13. Geräteschrank nach einem der vorhergehenden Ansprüche, **dadurch gekennzeichnet, daß** der Geräteschrank zum Absetzen eines Warnsignals im Gefahrenfall mit einer Datenleitung/Telefonleitung verbindbar ist.

14. Geräteschrank nach einem der vorhergehenden Ansprüche, **dadurch gekennzeichnet, daß** der Geräteschrank zum Absetzen eines Warnsignals im Gefahrenfall mit einem akustischen Signalgeber verbunden ist.

15. Verfahren zum Aufbau eines Geräteschranks nach einem der vorhergehenden Ansprüche während des Betriebs von Geräten, die in einem eigenen Geräteträger angeordnet sind, **dadurch gekennzeichnet, daß** der Geräteträger angehoben wird, daß der Geräteschrankboden (1) untergeschoben wird, daß Geräteschrankteile (2, 2'') montiert werden, daß die in die Schrankteile eingelassenen Brandschottrahmen (8) mit Brandschutzmaterial versehen werden und daß die nach außen führenden Kabelstränge in die Brandschottrahmen (8) eingelegt werden.

16. Verfahren zum Betrieb eines Geräteschranks nach einem der vorhergehenden Ansprüche, **dadurch gekennzeichnet, daß** im Falle einer überhöhten Temperatur im Geräteschrank ein Warnsignal ausgesendet wird und daß im Falle eines weiteren starken Temperaturanstiegs im Geräteschrank die Spannungsversorgung der eingebauten Geräte abgeschaltet wird.

17. Verfahren nach Anspruch 16, **dadurch gekennzeichnet, daß** im Brandfalle die Spannungsversorgung der eingebauten Geräte abgeschaltet wird.

## Claims

1. An equipment rack for installing electronic devices, comprising a base (1), wall parts (2, 2', 2", 3), at least one door (5) and a cover (4), apparatuses for fastening the devices, in particular plug-in holders, being situated in the equipment rack, and cable boxes being provided on the equipment rack, wherein the wall parts are removable; the base (1), wall parts (2, 2', 2", 3), cover (4) and doors (5) are made of a fireproof material; an air conditioning system (7) is provided for regulating the temperature in the equipment rack; the air conditioning system (7) has self-sealing vents (7') in the event of a fire; the cable boxes (8) are designed as fire stops that are self-sealing in the event of a fire; the doors (5) of the equipment rack are provided with an electromechanical locking mechanism which is unlockable by an actuator (9) mounted on the outside of the equipment rack; and the doors (5) of the equipment rack are provided with self-sealing seals in the event of a fire.

2. The equipment rack as recited in Claim 1, wherein instruments for monitoring and recording door openings, access attempts, fire events, the power supply, the proper operation of the air conditioning system (7) and the temperature in the equipment rack are present, which have corresponding sensors (10, 11) in the equipment rack; and the instruments are connected to means for switching off the power supply to the devices in hazardous situations.

3. The equipment rack as recited in one of the preceding claims, wherein vents (7') having expanding inserts are provided for sealing purposes in the event of an excessive rise in temperature.

4. The equipment rack as recited in one of the preceding claims, wherein the air conditioning system (7) may be inserted snugly into an opening (4') in the equipment rack provided for this purpose; and the vents (7') are situated on the housing of the air conditioning system (7).

5. The equipment rack as recited in one of the preceding claims, wherein an apparatus for air circulation/ventilation, which contains at least one fan, is situated in the equipment rack.

6. The equipment rack as recited in one of the preceding claims, wherein the fire stops (8) are equipped with expanding material for sealing purposes in the event of an excessive rise in temperature.

7. The equipment rack as recited in Claim 6, wherein the fire stops have, for assembly purposes, cables which are preconnected via a frame (8) which is open on one side and in which the expanding material and the cables are laid; and recesses or compartments are provided on the equipment rack parts for accommodating the fire stops.

8. The equipment rack as recited in one of the preceding claims, wherein at least parts (2') of the side walls (2) are removable for interconnecting multiple racks, and the racks are interconnectable at the openings thus produced, the joints being sealed by seals which expand in the event of an excessive rise in temperature.

9. The equipment rack as recited in one of the preceding claims, wherein a clearance is provided between the electronic devices and the doors (5) for laying connecting cables.

10. The equipment rack as recited in one of the preceding claims, wherein at least one female multipoint connector is provided in the equipment rack for connecting the devices.

11. The equipment rack as recited in one of the preceding claims, wherein power is supplied to the devices via a voltage monitoring apparatus.

12. The equipment rack as recited in one of the preceding claims, wherein a card reader (9) for magnetic or chip cards is situated on the outside of the equipment rack; and the locking mechanism for the door (5) is unlockable via a controller inside the equipment rack by inserting a card.

13. The equipment rack as recited in one of the preceding claims, wherein the equipment rack is connectable to a data line/telephone line for transmitting a warning signal in a hazardous situation.

14. The equipment rack as recited in one of the preceding claims, wherein the equipment rack is connectable to an acoustic signal transducer for transmitting a warning signal in a hazardous situation.

15. A method for constructing a equipment rack according to one of the preceding claims during the operation of devices which are situated in a separate device carrier, wherein the device carrier is raised; the equipment rack base (1) is lowered; equipment rack parts (2, 2") are mounted; the fire stops (8) introduced into the rack parts are provided with fireproof material; and the outward-extending cable sections are laid in the fire stop frames (8).

16. A method for operating an equipment rack as recited in one of the preceding claims, wherein a warning signal is transmitted in the event of overheating in the equipment rack; and the power supply to the installed devices is disconnected in the event that the temperature continues to rise in the equipment rack.

17. The method as recited in Claim 16, wherein the power supply to the installed devices is disconnected in the event of a fire.

## Revendications

1. Baie destinée à recevoir des modules électroniques, comportant un fond (1), des parties de paroi (2, 2', 2", 3), au moins une porte (5) et un couvercle (4), des dispositifs destinés à fixer les modules, en particulier des supports pour embrochables, étant disposés dans la baie et des traversées de câbles étant prévues sur la baie, **caractérisée en ce que** les parties de paroi sont démontables, que le fond (1), les parties de paroi (2, 2', 2", 3), le couvercle (4) et les portes (5) sont fabriqués dans un matériau réfractaire, qu'une installation de climatisation (7) servant à la régulation de la température dans la baie est prévue, que l'installation de climatisation (7) dispose d'orifices de ventilation (7') à fermeture automatique en cas d'incendie, que les traversées de câbles (8) sont réalisées sous la forme de cloisons coupe-feu auto-étanchéifiantes en cas d'incendie, que les portes (5) de la baie sont munies d'un système de verrouillage électromécanique qui peut être déverrouillé par un dispositif d'actionnement (9) placé à l'extérieur, sur la baie, et que les portes (5) de la baie sont munies de joints auto-étanchéifiants en cas d'incendie.

2. Baie selon la revendication 1, **caractérisée en ce que** des équipements pour la surveillance et l'enregistrement d'ouvertures de portes, de tentatives d'accès, d'incendies, de l'alimentation en tension, du fonctionnement correct de l'installation de climatisation (7) et de la température sont présents dans la baie et disposent de capteurs correspondants (10, 11) dans la baie et que les équipements sont reliés à des moyens qui coupent l'alimentation en tension des modules en cas de danger.

3. Baie selon l'une des revendications précédentes, **caractérisée en ce que** les orifices de ventilation (7') sont munis de garnitures moussantes pour assurer l'étanchéité en cas de fort échauffement.

4. Baie selon l'une des revendications précédentes, **caractérisée en ce que** l'installation de climatisation (7) peut être mise en place sur la baie en l'ajustant dans une ouverture (4') prévue à cet effet et que les orifices de ventilation (7') sont disposés sur le boîtier de l'installation de climatisation (7).

5. Baie selon l'une des revendications précédentes, **caractérisée en ce qu'**un dispositif de circulation d'air/ventilation qui contient au moins un ventilateur est disposé dans la baie.

6. Baie selon l'une des revendications précédentes, **caractérisée en ce que** les cloisons coupe-feu (8) sont équipées d'un matériau moussant pour assurer l'étanchéité en cas de fort échauffement.

7. Baie selon la revendication 6, **caractérisée en ce que** les cloisons coupe-feu disposent, pour le montage de câbles déjà raccordés, d'un cadre (8) ouvert d'un côté dans lequel le matériau moussant et les câbles sont insérés et que des évidements ou compartiments pour loger les cloisons coupe-feu sont prévus sur les parties de la baie.

8. Baie selon l'une des revendications précédentes, **caractérisée en ce que**, pour réunir ensemble plusieurs baies, au moins des parties (2') des parois latérales (2) sont amovibles et que les baies peuvent être réunies ensemble au niveau des ouvertures ainsi formées, les emplacements de raccordement étant rendus étanches par des joints moussant en cas de fort échauffement.

9. Baie selon l'une des revendications précédentes, **caractérisée en ce qu'**un espace libre est prévu entre les modules électroniques et les portes (5) pour la pose de câbles de raccordement.

10. Baie selon l'une des revendications précédentes, **caractérisée en ce qu'**au moins un bloc multiprise est prévu dans la baie pour raccorder les modules.

11. Baie selon l'une des revendications précédentes, **caractérisée en ce que** l'alimentation en tension des modules s'effectue par l'intermédiaire d'un dispositif de contrôle de la tension.

12. Baie selon l'une des revendications précédentes, **caractérisée en ce qu'**un lecteur de cartes (9) pour cartes magnétiques ou cartes à puce est disposé sur la baie, à l'extérieur, et que le système de verrouillage de la porte (5) peut être déverrouillé par l'insertion d'une carte, par l'intermédiaire d'un dispositif de commande situé à l'intérieur de la baie.

13. Baie selon l'une des revendications précédentes, **caractérisée en ce que** la baie peut être reliée à une ligne de transmission de données/ligne téléphonique pour lancer un signal d'alarme en cas de danger.

14. Baie selon l'une des revendications précédentes, **caractérisée en ce que** la baie est reliée à un émetteur de signaux acoustiques pour lancer un signal d'alarme en cas de danger.

15. Procédé de montage d'une baie selon l'une des revendications précédentes pendant le fonctionnement de modules qui sont disposés dans un support de module propre, **caractérisé en ce que** le support de module est soulevé, que le fond de la baie (1) est placé dessous, que des parties de la baie (2, 2') sont montées, que les cadres de cloison coupe-feu (8) encastrés dans les parties de baie sont munis de matériau ignifuge et que les faisceaux de câbles allant vers l'extérieur sont insérés dans les cadres de cloisons coupe-feu (8).

16. Procédé de fonctionnement d'une baie selon l'une des revendications précédentes, **caractérisé en ce que**, dans le cas d'une température trop élevée dans la baie, un signal d'alarme est émis et que, dans le cas d'une autre forte augmentation de température dans la baie, l'alimentation en tension des modules montés à l'intérieur est coupée.

17. Procédé selon la revendication 16, **caractérisé en ce que** l'alimentation en tension des modules montés à l'intérieur est coupée en cas d'incendie.
